**Europäisches Patentamt**

(19) **European Patent Office**

**Office européen des brevets**

(11) Veröffentlichungsnummer: **0 183 910**

**A2**

(12) # EUROPÄISCHE PATENTANMELDUNG

(21) Anmeldenummer: **85109108.2**

(22) Anmeldetag: **20.07.85**

(51) Int. Cl.⁴: **H 01 R 43/16**
**H 05 K 7/10**

(30) Priorität: **02.11.84 DE 3440109**

(43) Veröffentlichungstag der Anmeldung:
**11.06.86 Patentblatt 86/24**

(84) Benannte Vertragsstaaten:
**AT CH FR GB IT LI NL SE**

(71) Anmelder: **Kernforschungszentrum Karlsruhe GmbH**
**Weberstrasse 5**
**D-7500 Karlsruhe 1(DE)**

(72) Erfinder: **Ehrfeld, Wolfgang, Dr.**
**Reutstrasse 27**
**D-7500 Karlsruhe 41(DE)**

(72) Erfinder: **Hagmann, Peter, Dr.**
**Nagoldstrasse 9c**
**D-7514 Eggenstein-Leopoldshafen(DE)**

(72) Erfinder: **Münchmeyer, Dietrich, Dr.**
**Hagäckerstrasse 5**
**D-7513 Stutensee-Spöck(DE)**

(72) Erfinder: **Becker, Erwin Willy, Prof. Dr.**
**Strählerweg 18**
**D-7500 Karlsruhe 41(DE)**

(54) **Verfahren zur Herstellung verformbarer Vielfach-Verbindungen für den elektrischen Anschluss mikroelektronischer Bauelemente und nach diesem Verfahren hergesttellte Vielfachverbindungen.**

(57) Der Erfindung liegt die Aufgabe zugrunde, in gewissen Grenzen verformbare Vielfach-Verbindungen für den elektrischen Anschluß mikroelektronischer Bauelemente herzustellen, die bei möglichst geringem Platzbedarf die unterschiedliche thermische Ausdehnung von Chip und Substrat oder anderer ähnlich aufgebauter elektronischer, miteinander zu verbindender Bauelement ausgleichen.

Die Lösung dieser Aufgabe ist dadurch gekennzeichnet, daß aus einem durch energiereiche Strahlung in seinen Eigenschaften veränderbarem, plattenartigen Material durch partielles Bestrahlen und partielles Entfernen dieses Materials unter Ausnutzung der durch die Bestrahlung erzeugten unterschiedlichen Materialeigenschaften eine plattenartige Form erzeugt wird, die an vorgegebenen Positionen Strukturen von Verbindungselementen enthält, deren Höhe ein Vielfaches ihrer kleinsten lateralen Abmessungen beträgt, daß die Strukturen galvanisch mit Metall aufgefüllt werden, die galvanisch erzeugten Verbindungselmente auf einer Substratplatte oder einer Halteplatte fixiert werden, und die Form entfernt wird.

**Beschreibung:**                    - 1 -

Für die Herstellung von Mikrokontaktierungen monolithisch integrierter Mikroschaltungen ist es bekannt, die Kontaktstellen des Chips mit dem einen Ende und die hiermit zu verbindenden Anschlußelektroden des Chipträgers mit dem anderen Ende dünner Metalldrähte mittels Thermokompression oder durch Aufreiben zu verbinden, wobei verformbare Vielfach-Verbindungen entstehen (Kästner, Halbleiter-Technologie, Vogel-Verlag Würzburg, 1980, Seiten 88/89). Dabei können die Anschlußelektroden auf dem Chipträger wesentlich grössere Abstände haben als die Kontaktstellen des Chips; die Anschlußelektroden sind somit als Steckkontakte ausführbar. Damit erhält man zwar ein steckbares Bauteil, das leicht in eine größere elektronische Schalteinheit ein und ausgebaut werden kann, die hierfür erforderliche Einbaufläche beträgt jedoch ein Vielfaches der ChipFläche.

Es ist ferner bekannt, die Kontaktstellen über die gesamte Fläche des Chips zu verteilen, und mehrere Chips mit den Kontaktstellen direkt auf ein gemeinsames, Verbindungsleitungen in mehreren Lagen enthaltendes Keramiksubstrat aufzulöten ("Flip-chip bonding", vgl. z.B. L.S. Goldman, P.A.Totta, Solid State Technology, Band 26, Heft 6, 1983, Seiten 91-97). Dadurch lassen sich wesentlich höhere Integrationsdichten und wesentlich kürzere Signallaufzeiten als bei anderen Einbauverfahren erreichen. Da die Rückseiten der Chips bei dieser Einbauweise frei von mechanischen oder elektrischen Strukturen sind, ergibt sich zusätzlich die Möglichkeit, die Rückseiten über angedrückte Metallzylinder mit Wasser zu kühlen.

- 2 -

Das direkte Auflöten der Chips auf das Keramiksubstrat führt jedoch aufgrund der unterschiedlichen thermischen Ausdehnungskoeffizienten von Chip- und Substratmaterial bei Temperaturänderungen zu umso größeren mechanischen Belastungen der Lötverbindungen, je größer der Chip ist. Bei der angestrebten weiteren Vergrößerung der Chipfläche und der weiteren Verfeinerung der Leitungs- und Verbindungsstrukturen nimmt daher die Gefahr von Brüchen der starren Lötverbindungen stark zu.

Der Erfindung liegt die Aufgabe zugrunde, in gewissen Grenzen verformbare Vielfach-Verbindungen für den elektrischen Anschluß mikroelektronischer Bauelemente herzustellen, die bei möglichst geringem Platzbedarf die unterschiedliche thermische Ausdehnung von Chip und Substrat oder anderer ähnlich aufgebauter elektronischer, miteinander zu verbindender Bauelemente ausgleichen.

Zur Lösung dieser Aufgabe werden erfindungsgemäß die im Kennzeichen der Patentansprüche enthaltenen Maßnahmen vorgeschlagen.

Das erfindungsgemäße Verfahren gestattet es, zahlreiche in ausreichenden Grenzen verformbare Verbindungselemente mit den für einen platzsparenden Einbau mikroelektronischer Bauelemente erforderlichen außerordentlich geringen Abmessungen und Abständen gemeinsam herzustellen und zu fixieren. Trotz ausreichender Verformbarkeit in der Ebene der kritischen thermischen Ausdehnung sind die so hergestellten Vielfach-Verbindungen in der dazu senkrechten Richtung genügend steif, um beispielsweise bei der oben beschriebenen Wasserkühlung den Anpreßdruck der Kühlzylinder aufzufangen. Darüber

- 3 -

hinaus eröffnen die erfindungsgemäß hergestellten elektrischen Vielfach-Verbindungen die Möglichkeit einer forcierten Kühlung durch Einblasen von Gas in den durch die Verbindungselementen geschaffenen Raum zwischen den Chips und dem Substrat.

Die Erfindung wird im folgenden anhand der Zeichnungen näher erläutert:

Die Figuren 1 bis 4 zeigen schematisch das Herstellungsverfahren nach dem Prinzip von Anspruch 1;

die Figuren 5 bis 7 zeigen schematisch das Herstellungsverfahren nach dem Prinzip von Anspruch 3;

Die Figuren 8a, 8b zeigen eine Variante des Verbindungselements.

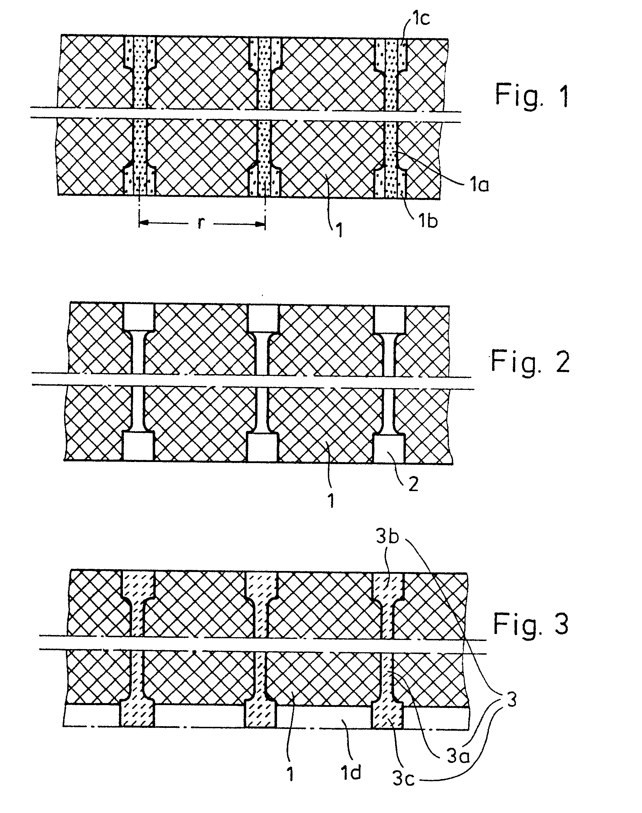

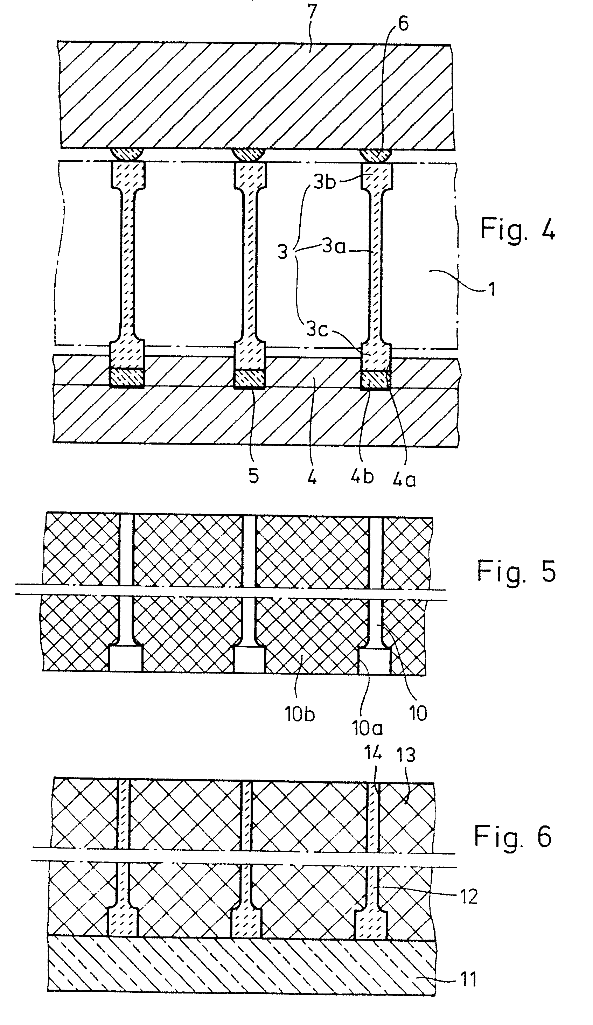

Die Figur 1 zeigt in stark vergrößertem Maßstab einen Querschnitt eines plattenförmigen Materials aus Polymethylmethacrylat (PMMA), im folgenden als Resistplatte 1 bezeichnet. Die Resistplatte 1 hat eine Dicke von ca. 500 µm und wird über eine Röntgenmaske (nicht dargestellt) mit energiereicher Röntgenstrahlung eines Synchrotrons partiell in einem vorgegebenen Rasterabstand r von ca. 300 µm durchstrahlt, so daß zylindrische Bereiche 1a mit einem Durchmesser von ca. 30 µm entstehen, deren Löslichkeit gegenüber den unbestrahlten Bereichen der Resistplatte 1 stark erhöht ist. Sodann erfolgt je eine weitere partielle Bestrahlung der Resistplatte von beiden Seiten 1b, 1c im selben Raster, deren Eindringtiefe jedoch geringer ist und deren Durchmesser ca. 70 μm beträgt. Die derart bestrahlten und dadurch löslich gemachten Bereiche 1a, 1b, 1c werden mit einem Entwickler, wie er z.B. in der DE-OS 30 39 110 beschrieben ist, entfernt, so daß eine Form mit Strukturen 2 der Verbindungselemente entsteht, wobei die Strukturen 2 an ihren Enden bundförmige Erweiterungen haben (Figur 2). Beim nächsten Schritt werden die Strukturen 2 galvanisch mit Nickel aufgefüllt, so daß Verbindungselemente 3 mit einem dünneren verformbaren mittleren Abschnitt 3a und verdickten Endbereichen 3b und 3c entstehen (Figur 3). Wie weiter aus der Figur 3 zu ersehen ist, wird nun auf einer Seite ein Teil 1d der Resistplatte 1 durch Bestrahlen mit einer Strahlung entsprechender Eindringtiefe und anschließendes Herauslösen entfernt, so daß die verdickten Endbereiche 3c der Verbindungselemente freiliegen. Nun werden die verdickten Endbereiche 3c der Verbindungselemente 3 in entsprechende Paßlöcher 4a einer keramischen Substratplatte 4 gesteckt und dadurch fixiert (Figur 4). Die Paßlöcher 4a sind teilweise mit einer Blei/Zinnlegierung 4b gefüllt, die bei der späteren Aufheizung (s.unten) die elektrische Verbindung zwischen den Verbindungselementen 3 und den Leiterbahnen 5 der aus mehreren Schichten bestehenden Substratplatte 4 sicherstellt. Sodann wird das restliche Material der Resistplatte 1 mit einem Lösungsmittel entfernt. Auf die verdickten Endbereich 3b der in der Substratplatte 4 fixierten Verbindungselemente 3 wird ein Chip 7 mit seinen in demselben Raster angeordneten, mit Lötperlen versehenen Anschlüssen 6 gelegt und die Gesamtanordnung in einem Ofen soweit aufgeheizt, daß die Verbindungselemente 3 sowohl mit den Leiterbahnen 5 der Substratplatte 4 als auch mit den Anschlüssen 6 verlötet werden.

Dabei können die Verbindungselemente 3 aufgrund ihrer verformbaren mittleren Abschnitte 3a unterschiedliche thermische Ausdehnungen von Chip und Substratplatte ausgleichen. Anstelle der vorbeschriebenen Art der Fixierung ist auch möglich, die Leiterbahnen 5 der Substratplatte 4 als Galvanikelektrode zu verwenden. In diesem Falle wird die Form mit den Strukturen 2 (Figur 2) unmittelbar so auf die Substratplatte 4 aufgebracht, daß die Strukturen 2 mit den Paßlöchern 4a in der Substratplatte 4 fluchten. Nach dem galvanischen Auffüllen der Strukturen 2 werden das Material der Resistplatte 1 entfernt und die Verbindungselemente 3 mit den Anschlüssen 6 des Chips 7 verlötet. In beiden Fällen entsteht zwischen Chip und Substratplatte ein Zwischenraum, der das Durchblasen eines Kühlgases gestattet.

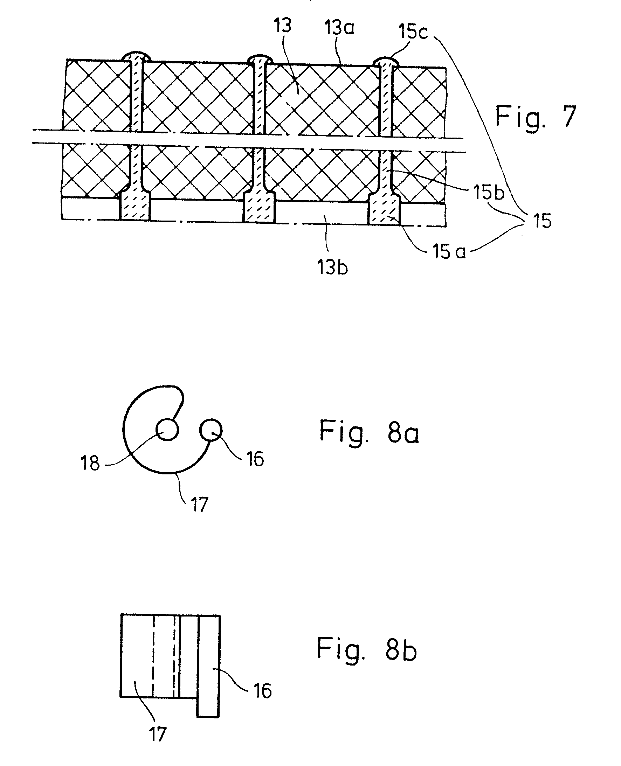

Nach einer weiteren Variante der Erfindung werden die Verbindungselemente nach der sogen. "Abformtechnik" hergestellt, bei der ein Mutterwerkzeug mehrfach mit einem Abformmaterial abgeformt wird, worauf die so erzeugten sekundären Formen galvanisch mit einem Metall aufgefüllt werden. In diesem Falle werden analog zu Figur 2 in einem plattenartigen Material 10b aus PMMA durch partielles Bestrahlen und partielles Entfernen von Material Strukturen 10 erzeugt, die mit Rücksicht auf das Abformen nur an einem Ende einen verdickten Endbereich 10a auf
weisen (Figur 5). Die Strukturen 10 werden galvanisch mit
Nickel aufgefüllt, wobei die Galvanikelektrode als
Halteplatte 11 an den so erzeugten primären Verbindungselementen 12 verbleibt (Figur 6). Dieses aus den
Teilen 11 und 12 bestehende Mutterwerkzeug wird nun
mehrfach mit einem durch energiereiche Strahlung in
seinen Eigenschaften veränderbaren Abformmaterial 13,
z.B. ebenfalls PMMA, abgeformt, so daß sekundäre, plattenförmige Formen entstehen, die die Strukturen 14 der
nebeneinander angeordneten, verformbaren Verbindungselemente enthalten. Die Formen werden nun ihrerseits
entsprechend Figur 3 galvanisch mit einem Metall beispielsweise Nickel aufgefüllt, so daß sekundäre Verbindungselemente 15 entstehen (Fig.7).Diese sekundären Verbindungselemente 15 haben einen dünneren verformbaren Bereich 15b und einen dickeren Endbereich 15a, der in einer
Substratplatte entsprechend Figur 4 fixiert wird, nachdem
ein Teil 13b der sekundären Form durch Bestrahlen mit
einer Strahlung entsprechender Eindringtiefe und
anschließendes Herauslösen entfernt worden ist. Durch
Übergalvanisieren über die Oberfläche 13a der Form hinaus
kann man auch bei dieser Technik einen oberen verdickten
Endbereich 15c erzeugen, der später mit dem Anschluß 6
des Chips 7 verlötet wird. Nach dem Fixieren der
Endbereiche 15a auf der Substratplatte 4 (Figur 4) wird
das restliche Abformmaterial 13 entfernt.

Nach dem erfindungsgemäßen Verfahren lassen sich nicht
nur säulenförmige Verbindungselemente mit entlang ihrer Höhe gleichbleibendem oder variierendem Querschnitt herstellen, sondern auch blattförmige Elemente mit verschiedenartigen Geometrien. Als Beispiel ist in den Figuren 8a und 8b die Draufsicht und die Seitenansicht eines Verbindungselementes dargestellt, bei dem zwei parallel zueinander angeordnete Stifte 16, 18 durch eine dünne Blattfeder 17 miteinander verbunden sind. Dabei ragt wenigstens einer der Stifte über die Höhe der Blattfeder hinaus, was durch nachträgliches galvanisches Verlängern der Stifte unter Verwendung gesonderter, nur die Strukturen der Stifte enthaltender Formen erreicht wird.

In den gewählten Beispielen wurde davon ausgegangen, daß die zu verbindenden mikroelektronischen Bauelemente ein Chip und eine Substratplatte seien. Selbstverständlich lassen sich auf analoge Weise auch andere mikroelektronische Bauelemente miteinander verbinden. Beispielsweise ist es möglich, zur weiteren Steigerung der Integrationsdichte von Mikroschaltungen die in Fig. 4 gezeigte Substratplatte durch einen weiteren Chip zu ersetzen, der über an seinem Rand angebrachten Kontaktstellen mit einer Substratplatte in Verbindung steht.

0183910

Kernforschungszentrum        Karlsruhe, den 18.7.1985
Karlsruhe GmbH               PLA 8460   Gb/he

<u>Patentansprüche:</u>

1. Verfahren zur Herstellung verformbarer Vielfach-Verbindungen für den elektrischen Anschluß mikroelektronischer Bauelemente, dadurch gekennzeichnet, daß
aus einem durch energiereiche Strahlung in seinen Eigenschaften veränderbarem, plattenartigen Material
durch partielles Bestrahlen und partielles Entfernen
dieses Materials unter Ausnutzung der durch die Bestrahlung erzeugten unterschiedlichen Materialeigenschaften eine plattenartige Form erzeugt wird, die
an vorgegebenen Positionen Strukturen (2) von Verbindungselementen enthält, deren Höhe ein Vielfaches
ihrer kleinsten lateralen Abmessungen beträgt, daß
die Strukturen (2) galvanisch mit Metall aufgefüllt
werden, die galvanisch erzeugten Verbindungselemente
(3) auf einer Substratplatte (4) oder einer Halteplatte (11) fixiert werden, und die Form entfernt wird.

2. Verfahren nach Anspruch 1, dadurch gekennzeichnet,
daß als energiereiche Strahlung Synchrotronstrahlung
verwendet wird, und das partielle Entfernen des Materials mit einem flüssigen Entwickler erfolgt.

0183910

3. Verfahren nach Anspruch 1 oder 2, dadurch gekennzeichnet, daß durch wiederholtes Abformen der auf einer Halteplatte (11) fixierten Verbindungselemente (12) mit einem Abformmaterial (13) mehrere die Strukturen (14) der verformbaren Verbindungselemente enthaltende sekundäre plattenartige Formen hergestellt werden, die galvanisch mit einem Metall aufgefüllt werden, die galvanisch erzeugten sekundären Verbindungselemente (15a) auf einer Substratplatte (4) fixiert werden, und die sekundären Formen entfernt werden.

4. Verfahren nach Anspruch 1, 2 oder 3, dadurch gekennzeichnet, daß die Fixierung der gemäß Anspruch 1 oder 2 erzeugten Verbindungselemente bzw. der gemäß Anspruch 3 erzeugten sekundären Verbindungselemente nach deren galvanischen Herstellung auf der Substratplatte (4) erfolgt, wozu weitere Teile des in Anspruch 1 erwähnten plattenartigen Materials bzw. des in Anspruch 3 erwähnten Abformmaterials, das in diesem Anwendungsfall durch energiereiche Strahlung in seinen Eigenschaften veränderbar ist, unter Ausnutzung der durch erneute Bestrahlung erzeugten unterschiedlichen Materialeigenschaften entfernt werden.

5. Verfahren nach Anspruch 1, 2 oder 3, dadurch gekennzeichnet, daß die Fixierung der gemäß Anspruch 1 oder 2 erzeugten Verbindungselemente bzw. der gemäß Anspruch 3 erzeugten sekundären Verbindungselemente durch Verwendung der Substratplatte (4) als Galvanikelektrode erfolgt.

6. Verformbare Verbindungselemente für Mikrokontaktierungen, hergestellt nach einem der Ansprüche 1 bis 5 dadurch gekennzeichnet, daß sie entlang ihrer gesamten Höhe konstanten Querschnitt haben.

- 3 -

7. Verfahren nach einem der vorstehenden Ansprüche, dadurch gekennzeichnet, daß das partielle Bestrahlen in mehreren aufeinander folgenden Schritten durchgeführt wird, wobei unterschiedliche Bereiche (1a, 1c) des plattenartigen Materials (1) mit Strahlung unterschiedlicher Eindringtiefe bestrahlt werden.

8. Verformbare Verbindungselemente für Mikrokontaktierungen, hergestellt nach Anspruch 7, dadurch gekennzeichnet, daß sie mindestens in einem Endbereich (3c, 3b) einen größeren Querschnitt als im übrigen Bereich (3a) haben.

9. Verformbare Verbindungselemente für Mikrokontaktierungen hergestellt nach einem der Ansprüche 1 bis 5, dadurch gekennzeichnet, daß jeweils zwei parallel zueinander angeordnete Stifte (8. 16) durch eine Blattfeder (17) miteinander verbunden sind.

0183910

Fig. 1

Fig. 2

Fig. 3

PLA 8460

0183910

Fig. 4

Fig. 5

Fig. 6

...

Fig. 7

Fig. 8a

Fig. 8b